(19) **Europäisches Patentamt / European Patent Office / Office européen des brevets**

(11) **EP 3 610 514 B1**

(12) **EUROPEAN PATENT SPECIFICATION**

(45) Date of publication and mention
of the grant of the patent:
**09.06.2021 Bulletin 2021/23**

(21) Application number: **18723612.0**

(22) Date of filing: **12.04.2018**

(51) Int Cl.:
*H01L 31/0224* (2006.01)   *H01L 51/00* (2006.01)
*H01L 51/44* (2006.01)   *H01L 31/0352* (2006.01)
*H01L 31/0749* (2012.01)

(86) International application number:
**PCT/NL2018/050224**

(87) International publication number:
**WO 2018/190711 (18.10.2018 Gazette 2018/42)**

(54) **PHOTOVOLTAIC ELEMENT AND METHOD OF MANUFACTURING THE SAME**

FOTOVOLTAIKELEMENT UND VERFAHREN ZUR HERSTELLUNG DAVON

ÉLÉMENT PHOTOVOLTAÏQUE ET SON PROCÉDÉ DE FABRICATION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.04.2017 EP 17166454**

(43) Date of publication of application:
**19.02.2020 Bulletin 2020/08**

(73) Proprietor: **Nederlandse Organisatie voor toegepast- natuurwetenschappelijk onderzoek TNO 2595 DA 's-Gravenhage (NL)**

(72) Inventors:
• **LIFKA, Herbert**
  **2595 DA 's-Gravenhage (NL)**

• **VEENSTRA, Siegfried Christiaan**
  **2595 DA 's-Gravenhage (NL)**
• **DORENKAMPER, Maarten Sander**
  **2595 DA 's-Gravenhage (NL)**
• **ANDRIESSEN, Hieronymus Antonius Josephus Maria**
  **2595 DA 's-Gravenhage (NL)**
• **VAN DEN HEUVEL, Huibert Johan**
  **2595 DA 's-Gravenhage (NL)**

(74) Representative: **V.O.**
  **P.O. Box 87930**
  **2508 DH Den Haag (NL)**

(56) References cited:
  **WO-A1-2016/038825     WO-A1-2017/060700**
  **CN-A- 105 140 398     US-A1- 2015 123 094**

**Description**

BACKGROUND OF THE INVENTION

Field of the invention

The present invention pertains to a photo-voltaic element.
The present invention further pertains to a method of manufacturing the same.

Related Art

A photo-voltaic element is disclosed in CN105140398 that comprises a conductive substrate; a uniform electron transport layer; a dielectric layer; a metal layer; and a perovskite layer as a photo-electric conversion layer. The latter has a plurality of channels through the dielectric layer and the metal layer that contact the electron transport layer. Accordingly the perovskite photo-to-electric conversion layer has its electric contacts for delivering electrical energy at the same side. Therewith it can be avoided that light to be converted has to pass through an electrode layer, as a result of which it would be attenuated before conversion.
The cited document also presents a method of manufacturing the photo-voltaic element disclosed therein. Therein a substrate is provided of a transparent conductive glass and an electron transport layer is deposited thereon by magnetron sputtering ZnO. Subsequently a layer of dispersed PS pellets having an original diameter of 2 um is deposited resulting in a hexagonal close-packed structure of said PS pellets. The PS ball diameter is subsequently reduced to 1 um by dry etching using RIE. A dielectric layer of Al2O3 is deposited thereon using ALD deposition followed by magneton sputtering of an Au layer. Subsequently, using a solvent and an ultrasonic treatment the PS pellets and the portions of the Al2O3 layer and the Au layer deposited thereon are removed, so that an Au mesh is obtained that is insulated from the electron transport layer. A perovskite layer is spin coated thereon that both contacts the Au mesh and the ZnO electron transport layer.
It is a disadvantage of this known process, a lift-off process, that the patterning process is not well controlled. As a result the boundaries of the openings in the insulator layer and the upper electrode layer are jagged and an unreliable or even non-working product is obtained.
It is noted that WO2017/060700, published after the priority date of this document also uses a lift-off process. As shown for example in FIG. 2, ) subsequently:

- the patterned resist layer is formed on the lower electrode (a)
- the insulator and HCE layer are deposited thereon (b)
- the patterned resist layer and the portions of the insulator layer and HCE layer present thereon are removed in the lift-off step (c).

SUMMARY OF THE INVENTION

It is a first object of the invention to provide a photo-voltaic element with an improved conversion efficiency.
) It is a second object of the invention to provide a method of manufacturing this improved photo-voltaic element.
In accordance with said first object, according to a first aspect, a photo-voltaic element is provided as claimed in claim 1.
In accordance with said second object, according to a second aspect, a method of manufacturing a photo-voltaic element is provided as claimed in claim 12.
The photo-voltaic element is provided as claimed in claim 1 comprises a stack of layers that at least include in the order named: a first electrode layer, a first charge carrier transport layer, an insulating layer, a second electrode layer, an second charge carrier transport layer, and a photo-electric conversion layer.
The first electrode layer is provided for receiving charge carriers of a first polarity, for example electrons, or alternatively for receiving holes as the charge carrier. The first charge carrier transport layer is provided for transport of charge carriers having the first polarity. E.g. if the first electrode layer is a cathode provided for receiving electrons as the charge carrier then the first charge carrier transport layer is an electron transport layer. Alternatively, if the first electrode layer is an anode provided for receiving holes as the charge carrier then the first charge carrier transport layer is a hole transport layer. The insulating layer may be provided of any sufficiently insulating organic or inorganic material. The second electrode layer is provided for receiving charge carriers of a second polarity opposite to the first polarity. Hence if the first electrode layer is a cathode then the second electrode layer is an anode and vice versa. The second charge carrier transport layer is provided for transport of charge carriers having the second polarity. Accordingly the second charge carrier transport layer is a hole transport layer if the second electrode layer is an anode and an electron transport layer if the second electrode layer is a cathode. The photo-electric conversion layer comprises a plurality of distributed extensions that extend through the second charge carrier transport layer, the second electrode layer and the insulating layer to the first charge carrier transport layer. Charge carriers of the first and the second polarity respectively have a first and a second mobility in the photo-electric conversion layer.
Because the photo-electric conversion layer is the uppermost layer of the stack (apart from e.g. a protection layer or encapsulation), it is not necessary that the various layers are transparent. Therewith one or more of the electrodes may be formed as a metal layer, for example an aluminum or a copper layer, possibly sandwiched between intermediate layers, e.g. as MoAlMo or CrCUCr. Nevertheless, embodiments may be contemplated wherein a transparent electrically conductive material is used for the electrodes, for example a transparent electrically conductive oxide like ITO. This is advantageous in that the device so obtained is bilaterally sensitive. Alternatively, this may be combined with a substrate having a reflecting surface. In this embodiment, light entering the device that is not converted in the photo-electric conversion layer is reflected back to the latter, so that it can still be (partially) converted.

Therewith the photo-electric conversion layer is electrically coupled to both the first charge carrier transport layer and the second charge carrier transport layer. In this arrangement solar radiation R does not need to traverse an electrode layer or a charge carrier transport layer, which contributes to an efficient operation of the photo-voltaic element.

An optimal conversion efficiency is achieved by the presence of a charge carrier transport layer between the first electrode layer and the photo-electric conversion layer as well as between the second electrode layer and the photo-electric conversion layer.

The extensions have an effective cross-section $D_{eff}$ in the range of 0.5 to 10 micron, and have an average pitch in the range of 1.1 to 5 times their effective cross-section. The effective cross-section is defined here as the diameter of a circle having an area corresponding to the cross-sectional area $A_\varnothing$ of the extensions. I.e.

$$D_{eff} = \sqrt{\frac{4A_\Phi}{\pi}}$$

The extensions are typically cylindrical. Alternatively the extensions may taper inward or outward. The extensions may have any cross-section, such as circular, square or triangular. The circumference O of the extensions is less than 10 times the effective diameter $D_{eff}$ and preferably less than 5 times the effective diameter $D_{eff}$. Therewith an optimum contact surface between the photo-electric conversion layer and the first charge carrier transport layer is achieved with minimum disruption of the intermediary layers, in particular the second electrode layer and the second charge carrier transport layer. Therewith a contact-surface of the photo-electric conversion layer with the first charge carrier transport layer has a first surface area, and a contact-surface of the photo-electric conversion layer with the second charge carrier transport layer has a second surface area. In the photo-voltaic element as claimed in claim 1, a ratio between the second surface area and the first surface area is approximately equal to a ratio between the first mobility and the second mobility.

In an embodiment of the photo-voltaic element the extensions taper outward in a direction from the first charge carrier transport layer to the second charge carrier layer.

In an embodiment thereof, material of the second charge carrier transport layer covers a surface of the second electrode surrounding the extensions. Therewith a contact surface provided for the photovoltaic layer is improved.

In an embodiment, the first charge carrier layer is absent in areas of the first electrode layer covered by the insulating layer. Also in this case, the stack formed in the product is deemed to comprise first charge carrier layer and a subsequent insulating layer, as the surface of the insulating layer will be above a surface of the first charge carrier layer, when traversing the layers starting from the substrate on which the layers are deposited.

In an embodiment the photo-electric conversion layer is provided of a perovskite material. Perovskite materials typical have a crystal structure of $ABX_3$, wherein A is an organic cation as methylammonium $(CH_3NH_3)^+$, B is an inorganic cation, usually lead (II) $(Pb^{2+})$, and X is a halogen atom such as iodine $(I^-)$, chlorine $(Cl^-)$ or bromine $(Br^-)$. Perovskite materials are particularly advantageous in that they can be processed relatively easily and in that their bandgap can be set to a desired value by a proper choice of the halide content. A typical example is methylammonium lead trihalide $(CH_3NH_3PbX_3)$, with an optical bandgap between 1.5 and 2.3 eV depending on halide content. Another more complex structure example is Cesium -formamidinum lead trihalide $(Cs_{0.05}(H_2NCHNH_2)_{0.95}PbI_{2.85}Br_{0.15})$ having a bandgap between 1.5 and 2.2 eV. Other metals such as tin may replace the role of Pb in perovskite materials. An example thereof is $CH_3NH_3SnI_3$. Also combinations of Sn with Pb perovskites having a wider bandgap in the range of 1.2 to 2.2 eV are possible. In another embodiment the photo-electric conversion layer is made of copper indium gallium selenide (CIGS).

The geometry of the substantially circular cylindrical extensions with an effective cross-section $D_{eff}$ in the range of 0.5 to 10 micron, and with an average pitch in the range of 1.1 to 5 times their effective cross-section makes it possible to optimally tune the contact-surface of the photo-voltaic layer with the first and the second charge carrier transport layer respectively dependent on the type of perovskite material used for the photo-voltaic layer. This is favorable, in that the ratio of mobility for holes and electrons may differ. E.g. if for a certain perovskite the mobility of electrons is 3 time higher than for holes, the surface area of the HTL preferably is approximately 3x the surface area of the ETL for an optimal efficiency.

The method as claimed in claim 12 enables manufacturing the photo-voltaic element of claim 1. The claimed method is recited in claim 12.

In an embodiment of the method the second charge carrier transport layer is deposited with an electroplating process and subsequent to removing the resist layer, and preceding depositing and curing a photo-electric conversion layer.

In an embodiment the first charge carrier transport layer is deposited with an electroplating process subsequent to removing the resist layer, and preceding depositing the second charge carrier layer.

The method according to the present invention enables the deposition of a thicker stack of layers on the first charge carrier transport layer than would be possible when using the pellet based approach known from the prior art. In this way the second charge carrier transport layer can be provided, therewith significantly improving efficiency of the photo-voltaic element.

Various methods may be used for depositing and applying layers. These methods may include spin-coating, printing methods, slot-die coating and vapor deposition methods like physical vapor deposition (e.g. E-beam PVD, Sputter PVD), (spatial) Atomic Layer Deposition ((s)ALD), and chemical vapor deposition (e.g. plasma-enhanced chemical vapor deposition (PECVD)).

Etching processes may be applied to remove a material (or a part of the material) from a surface either by a chemical reaction generated by the use of a reactive mix of gases (plasma-etching) or by submerging the substrates in a reactive solution where the layer is removed by dissolution or chemical reaction (wet-etching).

A selective etching is made possible by using a mask that locally protects the underlying layer(s). A patterning in such a mask may be obtained for example by optical lithography wherein light is used to transfer a geometric pattern from a photo-mask to a light sensitive chemical photoresist on the substrate. Also imprinting can be applied to pattern the mask. Alternatively the mask may be directly applied in the desired pattern, for example by printing.

BRIEF DESCRIPTION OF THE DRAWINGS

These and other aspects are described in more detail with reference to the drawing. Therein:

FIG. 1A schematically shows a top-view of a semi-finished product obtained during performing a method according to the second aspect,
FIG. 1B shows a cross-section according to IB-IB in FIG. 1A,
FIG. 2A shows a top-view corresponding to the area IIA of a semi-finished product obtained after an additional manufacturing step of a method according to the second aspect,
FIG. 2B shows a cross-section according to IIB-IIB in FIG. 2A,
FIG. 3A shows a top-view corresponding to the area IIA of a semi-finished product obtained after a further additional manufacturing step of a method according to the second aspect,
FIG. 3B shows a cross-section according to IIIB-IIIB in FIG. 3A,
FIG. 4A shows a top-view corresponding to the area IIA of a semi-finished product obtained after a still further additional manufacturing step of a method according to the second aspect,
FIG. 4B shows a cross-section according to IVB-IVB in FIG. 4A,
FIG. 4C shows in the same cross-section an optional manufacturing step of a method according to the second aspect,
FIG. 4D shows in the same cross-section an alternative optional manufacturing step of a method according to the second aspect,
FIG. 4E shows in the same cross-section a subsequent alternative optional manufacturing step of a method according to the second aspect,
FIG. 4F shows in the same cross-section a further subsequent alternative optional manufacturing step of a method according to the second aspect,
FIG. 4G shows in the same cross-section an alternative embodiment resulting from a still further subsequent alternative optional manufacturing step following the step illustrated in FIG. 4F,
FIG. 5 shows in the same cross-section a first embodiment of a photo-voltaic element according to the first aspect obtained after a further manufacturing step of a method according to the second aspect,
FIG. 6 shows in the same cross-section a second embodiment of a photo-voltaic element according to the first aspect,
FIG. 7 shows in the same cross-section a third embodiment of a photo-voltaic element according to the first aspect,
FIG. 8A shows a top-view corresponding to the area IIA of a fourth embodiment of a photo-voltaic element according to the first aspect,
FIG. 8B shows a cross-section according to VIIIB-VIIIB in FIG. 8A,
FIG. 9A shows a top-view corresponding to the area IIA of a semi-finished product obtained after an additional manufacturing step of a method according to the second aspect,
FIG. 9B shows a cross-section according to IXB-IXB in FIG. 9A,
FIG. 10A shows a top-view corresponding to the area IIA of a semi-finished product obtained after an additional manufacturing step of a method according to the second aspect,
FIG. 10B shows a cross-section according to XB-XB in FIG. 10A,
FIG. 11A shows a top-view corresponding to the area IIA of a semi-finished product obtained after an additional manufacturing step of a method according to the second aspect,
FIG. 11B shows a cross-section according to XIB-XIB in FIG. 11A,
FIG. 12A shows a top-view corresponding to the area IIA of a semi-finished product obtained after an additional manufacturing step of a method according to the second aspect,
FIG. 12B shows a cross-section according to XIIB-XIIB in FIG. 12A,

FIG. 12C shows a portion of the surface of the semi-finished product of FIG. 4B in more detail,

FIG. 12D shows a portion of the surface of the semi-finished product of FIG. 12B in more detail,

FIG. 13 shows a product obtained after the step of FIG. 12A, 12B,

FIG. 14A shows a top-view corresponding to the area IIA of a semi-finished product obtained after an additional manufacturing step of a method according to the second aspect,

FIG. 14B shows a cross-section according to XIVB-XIVB in FIG. 14A,

FIG. 15A shows a top-view corresponding to the area IIA of a semi-finished product obtained after an additional manufacturing step of a method according to the second aspect,

FIG. 15B shows a cross-section according to XVB-XVB in FIG. 15A,

FIG. 16 shows a product obtained after the step of FIG. 15A, 15B,

FIG. 17A shows a top-view corresponding to the area IIA of a semi-finished product obtained after an additional manufacturing step of a method according to the second aspect,

FIG. 17B shows a cross-section according to XVIIB-XVIIB in FIG. 17A.

DETAILED DESCRIPTION OF EMBODIMENTS

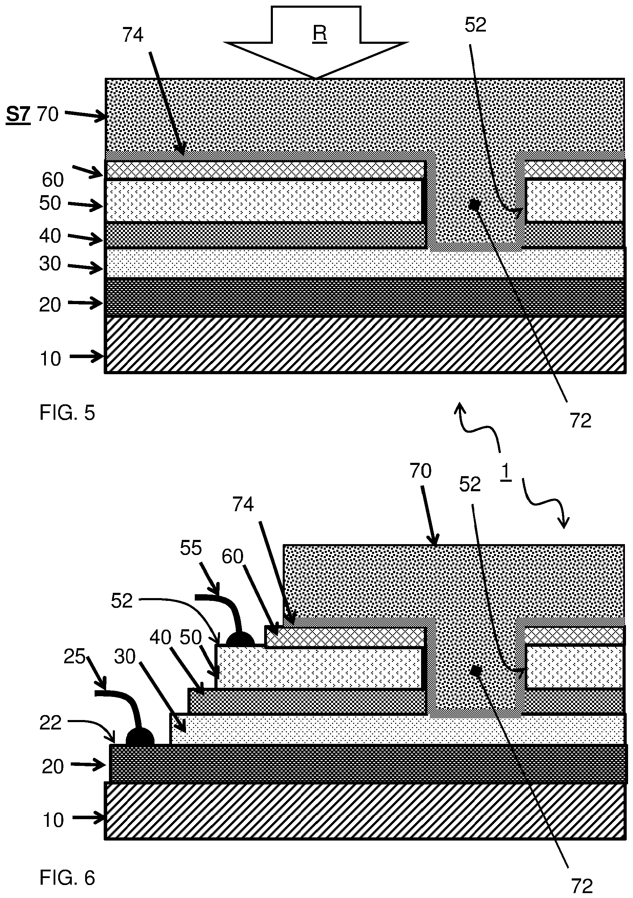

Fig. 5 schematically shows a photo-voltaic element 1. The photo-voltaic element 1 comprises a substrate 10 and a stack of layers arranged thereon. The substrate 10 may be formed of a rigid material such as a metal (e.g. steel, copper or aluminum), silicon or glass or of a flexible material such as a polymer, e.g. a polymer like polyethylene terephthalate (PET), polyethylene naphthalate (PEN), or polyimide (PI). Also thin metal or glass are suitable substrates. If the substrate is conducting, an isolating layer may be deposited on that substrate to isolate the electrode from the substrate. Dependent on the application a thickness of the substrate may be selected in the range of a relatively small value e.g. 50 micron and a relatively large value, e.g. a few mm or more. The stack of layers subsequently includes at least a first electrode layer 20, a first charge carrier transport layer 30, an insulating layer 40, a second electrode layer 50, a second charge carrier transport layer 60, and a photo-electric conversion layer 70.

The first electrode layer 20 is provided for receiving charge carriers of a first polarity. In the embodiment shown the first electrode layer 20 is an anode, i.e. arranged for receiving holes as the charge carriers. Dependent on the lateral size of the photo-voltaic element 1 the first electrode layer 20 may for example have a thickness in the range of a few tens to a few hundreds of nanometers or even more. In the embodiment shown the first electrode layer 20 includes an aluminum sub layer having a thickness of 190 nm, which is sandwiched between a pair of nickel layers, each having a thickness of 5 nm. In another example the first electrode layer is of molybdenum. In an embodiment where the substrate is provided of a metal, it may also serve as a first electrode layer 20.

In the embodiment shown the first charge carrier transport layer 30 is a hole transport layer, having a thickness in the range of 10 to 200 nm. In the embodiment shown the hole transport layer is formed by a nickeloxide layer having a thickness of 50 nm. In another example the hole transport layer is formed by a MoSe layer.

An insulating layer 40 is provided of an organic, e.g. a polymer, or inorganic insulating material, such as a metal oxide. Also a stack of materials can be used. Dependent on the material selected for the insulating layer, it may have a thickness in the range of 10 to 200 nm for example, but also a substantially thicker insulating layer may be applied. In the embodiment shown the insulating layer 40 is provided as a $SiO_2$ layer having a thickness of 100 nm.

A second electrode layer 50 for receiving charge carriers of a second polarity opposite to said first polarity is arranged on the insulating layer 40. In this case the second electrode layer 50 is a cathode. Any sufficiently conducting material can be used for this purpose at a thickness depending on the lateral size of the photo-voltaic element 1. Typically the thickness of the second electrode layer 50 is of the same order of magnitude as the thickness of the first electrode layer 20, so that they have approximately the same conductivity and neither of them forms a bottleneck. In the embodiment shown the second electrode layer 50 is an aluminum layer with a thickness of 200 nm. In some embodiments the second electrode layer 50 may have a thickness greater than that of the first electrode layer 20, e.g. 1.5 times a thickness of the first electrode layer 20, to compensate for the presence of the openings provided in the second electrode layer 50.

A second charge carrier transport layer 60 for transport of charge carriers having said the second polarity, opposite to the first polarity layer is arranged upon the second electrode layer 50. In this case the second charge carrier transport layer 60 is an electron transport layer. The second charge carrier transport layer 60, here an electron transport layer may have a thickness in the range of a few nm, e.g. 5 nm to a few tens of nm, e.g. 50 nm. In the embodiment shown the second charge carrier transport layer 60 is a $TiO_2$ layer having thickness of 15 nm. Other suitable materials for an electron transport layer are for example $SnO_2$, $ZrO_2$ and ZnO:S.

A photo-electric conversion layer 70 is provided upon the second charge carrier transport layer 60. The photo-electric conversion layer 70 has a plurality of distributed, typically cylindrical, extensions 72 that extend through the second charge carrier transport layer 60, the second electrode layer 50 and the insulating layer 40 to the first charge carrier transport layer 30. Therewith the photo-electric conversion layer 70 is electrically coupled to both the first charge carrier transport layer 30 and the second charge carrier transport layer 60. In this arrangement solar radiation R does not need to traverse an electrode layer or a charge carrier transport layer which contributes to an efficient operation of the photo-voltaic element 1. In the embodiment shown the extensions 72 have an effective cross-section $D_{eff}$ in the range of 0.5 to 10 micron, and have an average pitch in the range of 1.1 to 5 times their effective cross-section. The effective cross-section is defined here as the diameter of a circle having an area corresponding to the cross-sectional area $A_\varnothing$ of

$$D_{eff} = \sqrt{\frac{4A_\Phi}{\pi}}$$

the extensions. I.e.

The extensions may have any cross-section, such as circular, square or triangular. Preferably, a circumference O of the extensions is less than 10 times the effective diameter $D_{eff}$ and even more preferably less than 5 times the effective diameter $D_{eff}$.

In the embodiment the photo-electric conversion layer is provided of a perovskite material, such as methylammonium lead trihalide ($CH_3NH_3PbX_3$), or Cesium-formamidinum lead trihalide ($Cs_{0.05}(H_2NCHNH_2)_{0.95}PbI_{2.85}Br_{0.15}$) .. Alternatively a tin based perovskite material, such as $CH_3NH_3SnI_3$ may be used. Also more complex perovskite materials may be applied, for example containing a combination of different cations. Also other materials, such as copper indium gallium selenide (CIGS) are suitable.

In the embodiment shown the second electrode layer 50 has anodized edge surfaces 52 facing the extensions 72 of the photo-electric conversion layer 70. This avoids direct contact between the second electrode layer and the photo-electric conversion layer.

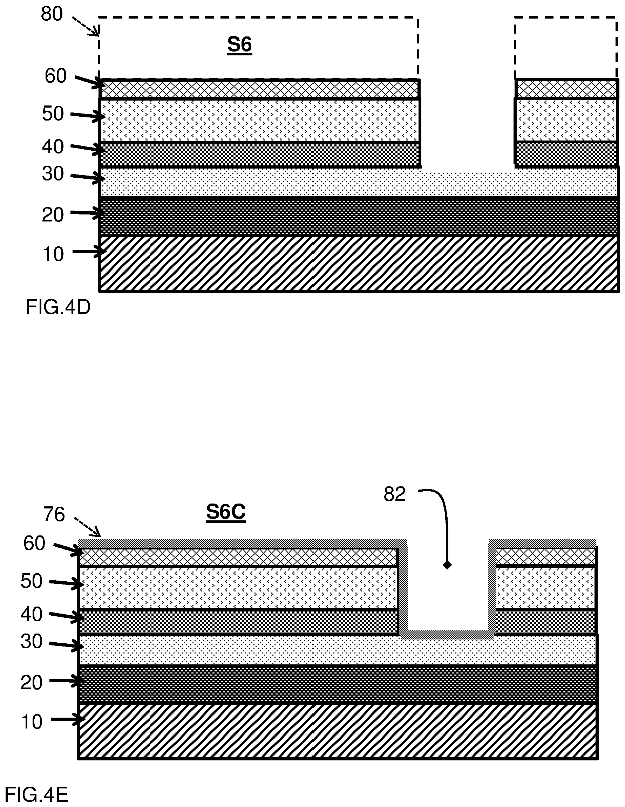

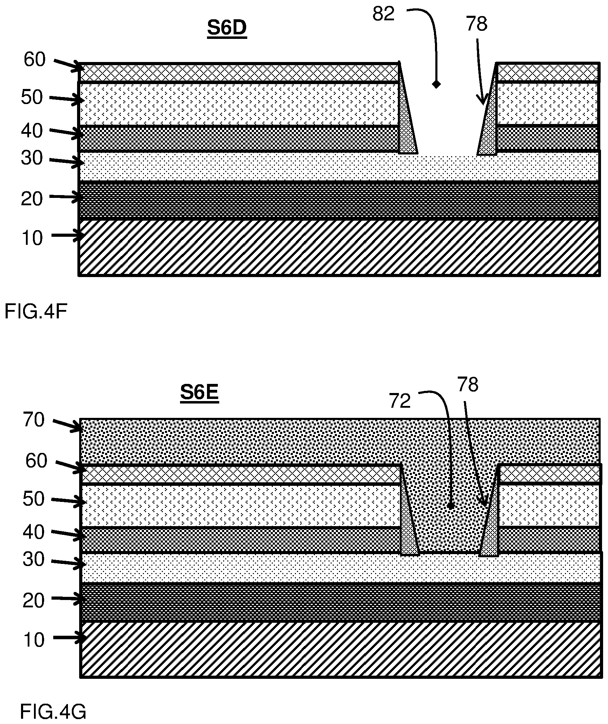

FIG. 4G illustrates an alternative embodiment wherein such direct contact is avoided. Therein the openings 82 are provided with an insulating wall 78, e.g. of a ceramic material. The specific steps for manufacturing this embodiment are described in more detail below with reference to FIG. 4D to FIG. 4G.

FIG. 6 shows an embodiment of the photo-voltaic element 1 of the invention wherein an edge portion 22 of an upper surface of the first electrode layer 20 is kept free from material of the first charge carrier transport layer 30 and is provided with a first electrical contact 25. Also an edge portion 52 of an upper surface of the second electrode layer 50 is kept free from material of the second charge carrier transport layer 60 and is provided with a second electrical contact 55. Another possibility is to remove the carrier transport layer 30 and isolator 40 with e.g. laser ablation before deposition of electrode 50, so a contact can be made from electrode 50 to electrode 20. Also before deposition of charge carrier transport layer 30 a laser step could be used to interrupt the electrode 20.

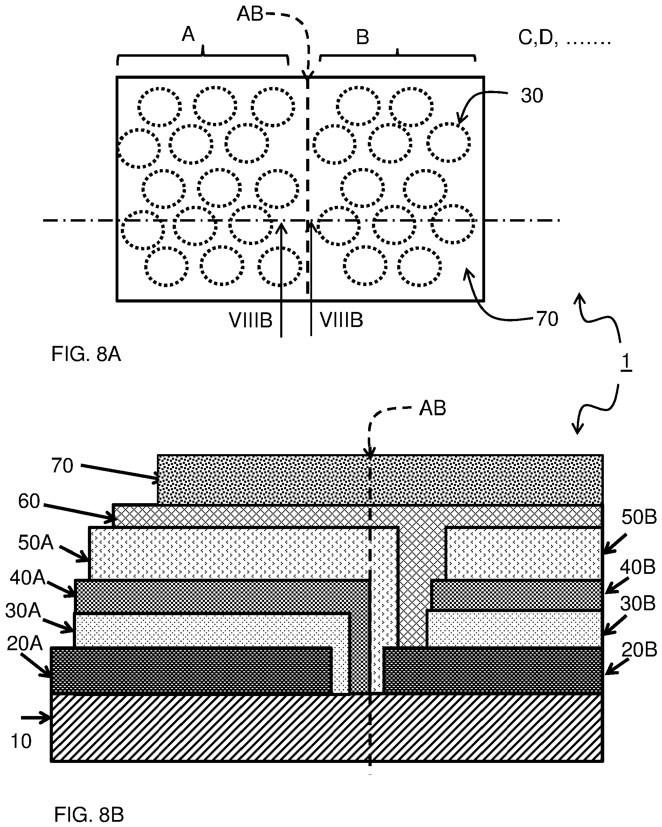

FIGs. 8A and 8B show a further embodiment of a photo-voltaic element according to the invention. Therein FIG. 8A shows a top-view and FIG. 8B shows a cross-section of a portion of the device according to VIIIB-VIIIB in FIG. 8A. In this further embodiment the first electrode layer 20, the first charge carrier transport layer 30, the insulating layer 40 and the second electrode layer 50 are provided as a plurality of layer segments. Therein a plurality of lateral sub-stack segments is formed. By way of example two lateral sub-stack segments A, B are shown in this case. However in practice the photo-voltaic element may have a larger number of lateral sub-stack segments C, D, ... e.g. 10 or 100 or more, depending on a required lateral size of the photo-voltaic element.

As shown in FIG. 8B each layer segment A,B comprises a first electrode layer segment 20A, 20B, a first charge carrier transport layer segment 30A, 30B, an insulating layer segment 40A, 40B and a second electrode layer segment 50A, 50B. The second charge carrier transport layer 60 and the photo-electric conversion layer 70 are formed as continuous layers. A second electrode layer segment 50A of a lateral sub-stack segment A extends over a first electrode layer segment (20B) in a neighboring sub-stack segment B. Therewith an electrical connection is formed between the second electrode layer segment 50A of the lateral sub-stack segment A and the first electrode layer segment 20B in the neighboring lateral sub-stack segment. In this way the photo-voltaic element is formed as a plurality of serially connected modules, which makes it possible to reduce resistive losses as compared to a photo-voltaic element that is not partitioned into serially connected modules. It could alternatively be contemplated to serially arrange a plurality of smaller photo-voltaic elements. It is however an advantage of the embodiment of FIG. 8A, 8B that external connection elements are avoided. A photo-voltaic element as shown in FIG. 8A, 8B could for example be provided as a single elongate product applied on a foil, e.g. delivered in a length of tens to hundreds of meter on a roll.

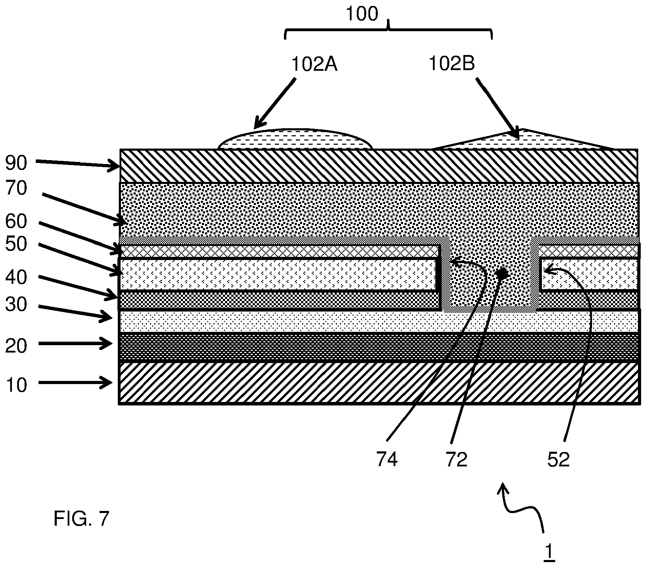

As shown in FIG. 7 additional layers may be provided. In the embodiment of FIG. 7 for example a barrier 90 is arranged over said photo-electric conversion layer 70. Suitable materials for the barrier are metal oxides, such as SiOx and SiNx. In practice the barrier 90 may comprise a plurality of layers, such as a stack of inorganic layers having a mutually different composition. Also a combination of inorganic layers and organic layers may be used. For example a barrier 90 may be formed by a first and a second inorganic layer that sandwich an organic layer. For a good light in coupling it is preferred that the materials used for the barrier 90 have a refractive index lower than that of the photo-electric conversion layer 70.

In the embodiment shown light in coupling is further improved by a light in coupling structure 100 arranged over the barrier 90. In the embodiment shown the light in coupling structure comprises a plurality of light in coupling elements 102A, 102B. For example semi-spherical or pyramidal shaped light in coupling elements may be used.

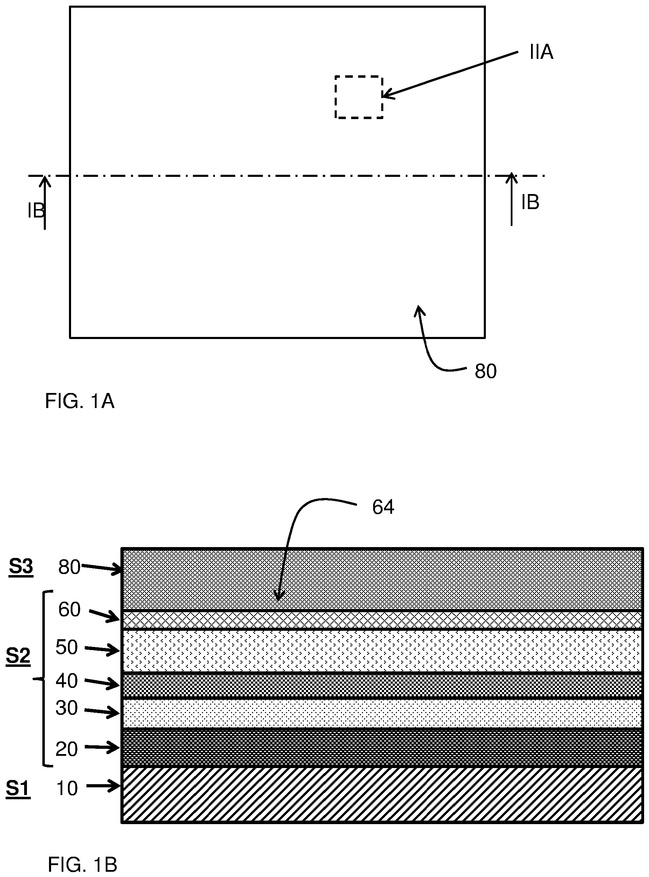

A method of manufacturing a photo-voltaic element is now disclosed with reference to FIG. 1 to 5.

FIG. 1A, 1B show the intermediate product obtained after a first three steps. Therein FIG. 1A shows a top-view and FIG. 1B shows a cross-section according to IB-IB in FIG. 1A.

Therein a substrate is 10 is provided in a first step S1. Then in a second step S2 a stack of layers is deposited thereon that comprise at least in the order named a first electrode layer 20, a first charge carrier transport layer 30, an insulating layer 40, a second electrode layer 50 and a second charge carrier transport layer.

The first electrode layer 20 is provided for receiving charge carriers of a first polarity. The first electrode layer 20 may for example be an anode, i.e. arranged for receiving holes as the charge carriers. Alternatively the first electrode layer 20 may be a cathode, i.e. arranged for receiving electrons as the charge carriers. In an embodiment the first electrode layer 20 is deposited with a PVD (physical vapor deposition) method, for example using E-beam PVD. In this example the first electrode layer 20 was provided as a stack of sub-layers obtained by subsequently depositing a first sub-layer of nickel having a thickness of 5 nm, an aluminum layer having a thickness of 190 nm and a second sub-layer of nickel also having a thickness of 5 nm. Then spin-coating (1000 rpm) was used to deposit a NiO layer as the first charge carrier transport layer 30, here a hole transport layer.

An insulating layer 40 was then deposited in a first and a second stage. In the first of these stages a first, 100 nm thick, sublayer of $SiO_x$ was deposited by electron-beam deposition and in the second stage a second sublayer of $SiO_x$, also having a thickness of 100 nm was deposited by PECVD. Then a second electrode layer 50, here a cathode layer of aluminum at a thickness of 200 nm was formed using the same method and conditions as those applied for the deposition of the aluminum sub-layer of the first electrode layer 20.

A second charge carrier transport layer 60, here an electron transport layer was then deposited. In this case electron-beam vapor deposition was used to deposit a $TiO_x$ layer with a thickness of 15 nm of linear titanium dioxide (TiOx).

The insulating layer 40 and the layers 50, 60 form a sub-stack having an upper surface 64. In a third step S3, here using spin coating a resist layer 80, here a photo-resist layer having a thickness of 1.6 micron was deposited on this upper surface 64. In other implementations the resist layer may be an imprint-resist layer.

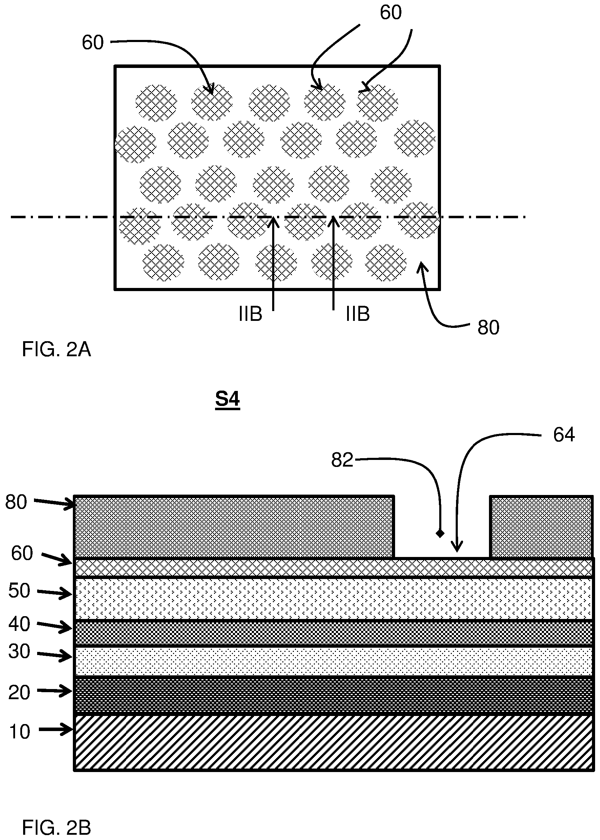

FIG. 2A, 2B show a subsequent step S4. Therein FIG. 2A shows a top-view of an intermediate product resulting from this step S4 and FIG. 2B shows a cross-section according to IIB-IIB in FIG. 2A. In this subsequent step regularly distributed openings 82 giving access to the upper surface 64 are formed in the resist layer 80. In this embodiment contact lithography was used for this purpose. Using the method described herewith samples were prepared having openings with diameter in the range of 0,5 - 5 $\mu$m and a distance between neighboring openings in the range of 1 - 5 $\mu$m. Therewith a pitch between 1 and 10 $\mu$m is obtained. The openings having an effective cross-section D in the range of 0.5 to 10 micron, and have an average pitch in the range of 1.1 to 5 times the effective cross-section.

Instead of patterning an originally homogeneous resist layer, it is alternatively possible to directly depositing the resist layer in the desired pattern, for example using a printing technique.

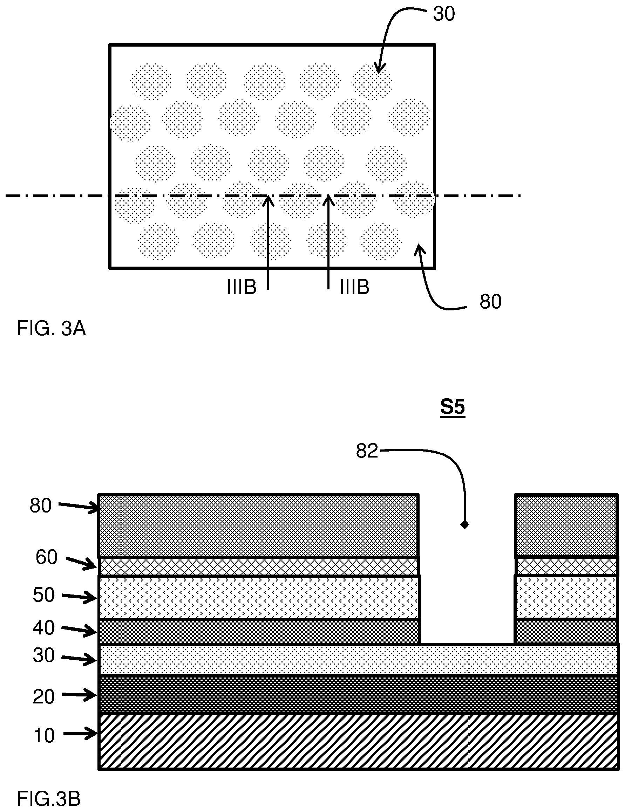

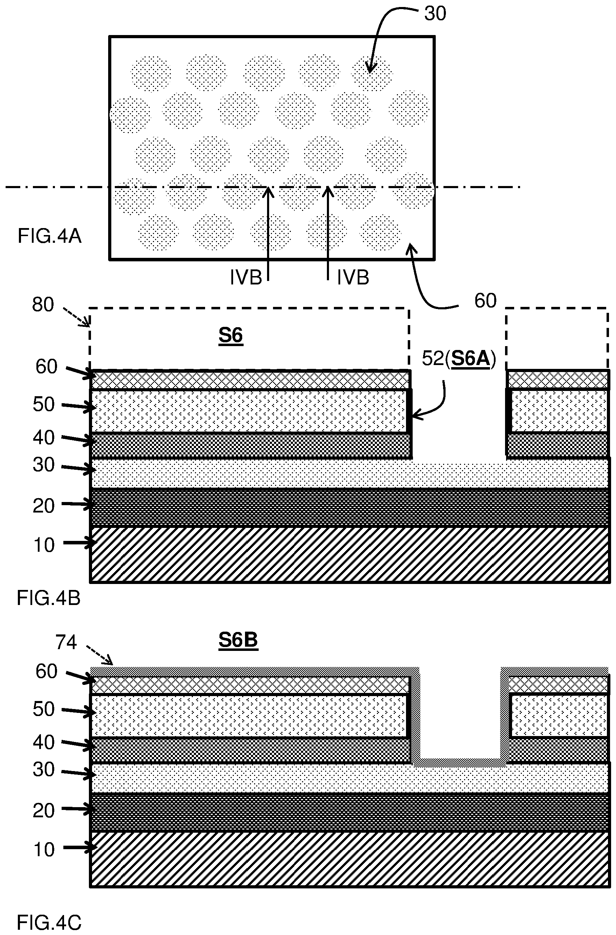

FIGs. 3A and 3B show a subsequent step S5, wherein material of the sub-stack 40, 50, 60 facing the openings 82 is selectively removed. Therein FIG. 3A shows a top-view of the semi-finished product obtained after this step S5 and FIG. 3B shows a cross-section according to IIIB-IIIB in FIG. 3A. Step S5 involves etching the upper layers 50, 60 by plasma etching. Then the insulating $SiO_x$ layer is etched with a further plasma etching process. The photo-resist layer 80 is then fully removed (Step S6), for example by oxygen plasma-etching as illustrated in FIGs. 4A and 4B. Therein FIG. 4A is a top-view and FIG. 4B shows a cross-section according to IVB-IVB in FIG. 4A.

As shown in FIG. 5, in a step S7, subsequent to this step S6, a photo-electric conversion layer 70 is deposited (for example by spin-coating) and cured. Optional pre-processing steps, S6A and S6B may be performed after removal of the resist layer 80 and before deposition of the photo-electric conversion layer 70.

A first optional pre-processing step S6A is illustrated in FIG. 4B. Therein an edge surface 52 of the second electrode layer 50 is anodized. This edge surface 52 was formed by the step of etching S5. This anodization process an insulating layer is formed on the edge surface 52 therewith avoiding a direct contact between the second electrode layer 50 and the photo-electric conversion layer 70.

FIG. 4C illustrates a second optional pre-processing step S6B. Therein to facilitate the deposition in step S7, an atomic layer deposition process (ALD) may be used to deposit a thin growth layer 74, e.g. applying a $TiO_2$ layer with a few sALD cycles.

FIG. 4D-4G shows an alternative approach for preventing a direct electrical contact between the second electrode layer 50 and the photo-electric conversion layer 70. After removal (S6) of the patterned resist layer 80 as shown in FIG. 4D, a layer 76 of an insulating material is conformally deposited (Step S6C) on the semi-finished product of FIG. 4D, therewith obtaining the semifinished product of FIG. 4E. Then an anisotropic etch step S6D, e.g. a plasma etch step is applied. The anisotropic etch step S6D removes the insulating material from the surface of the second charge carrier transport layer 60 and from the surface portions of the first charge carrier transport layer 30 within the openings 82 but keeps a layer of the insulating material on the walls of the openings 82 intact. Subsequent to this step S6D the photo-electric conversion layer can be deposited (S6E) as shown in FIG. 4G.

Upon completion the substrate 10 may be removed. For example this may be the case if an electrode layer, e.g. the first electrode layer 20 provides sufficient structural integrity. Alternatively, or in addition mechanical support may be provided by further layers applied on the photo-electric conversion layer 70.

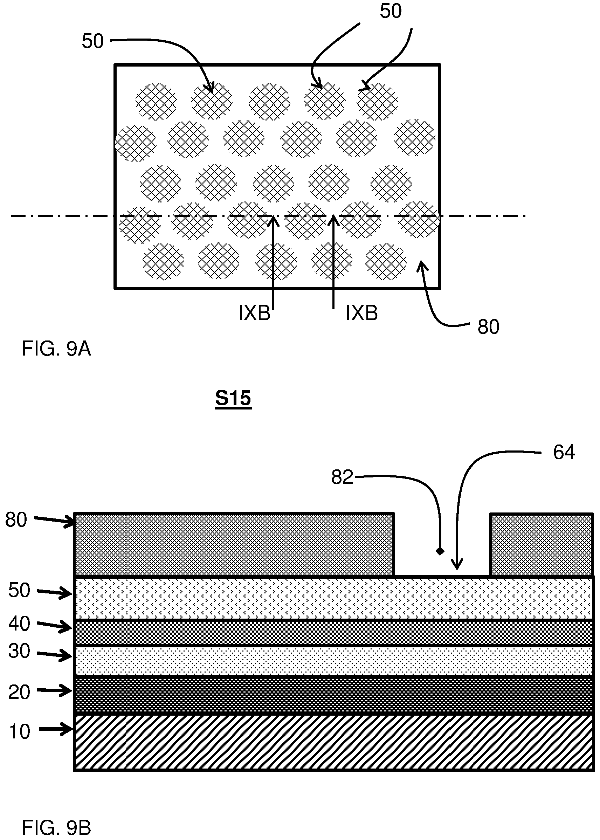

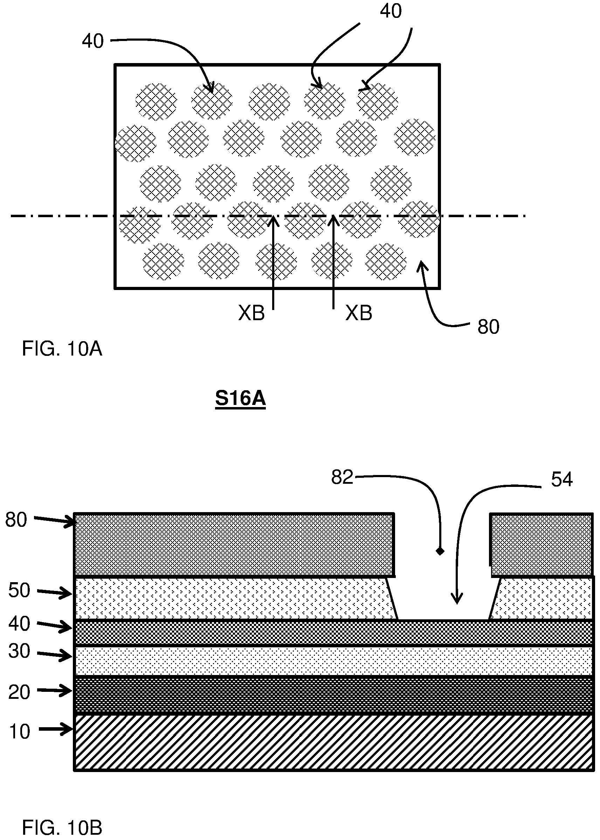

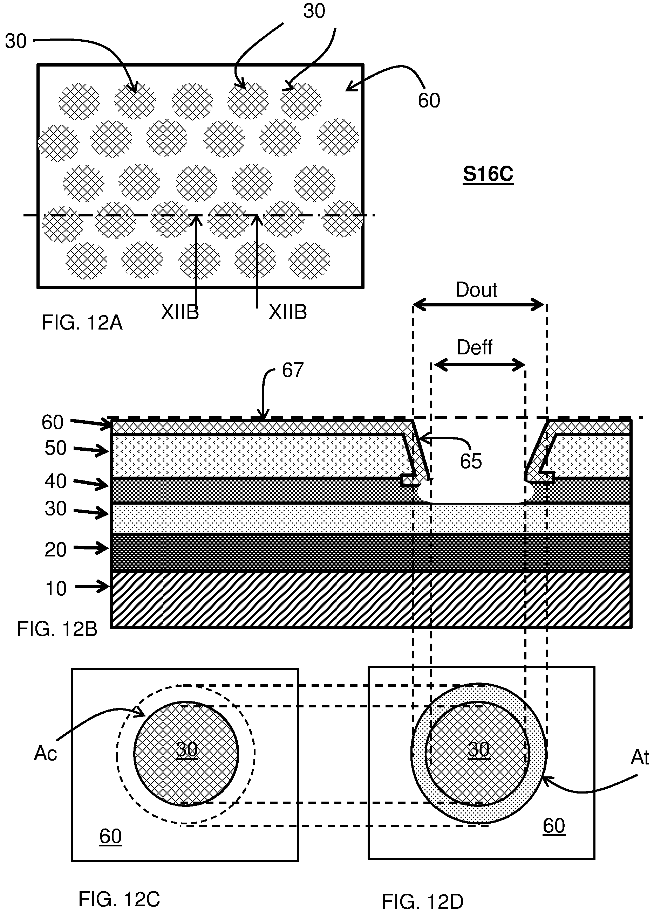

FIG. 9A, 9B, 10A, 10B, 11A, 11B, 12A, 12B and 13 show a further alternative embodiment of a method of manufacturing. Therein FIG. 9A, 9B show a semi-finished product that is obtained after step S15 of this embodiment. The steps of this embodiment up to and including S15 of this embodiment correspond to those disclosed herein for steps S1-S5 of the embodiment of FIG. 1A, 1B, 2A, 2B and 3A, 3B, except for the fact that the step corresponding to step S2, does not include deposition of a charge carrier transport layer 60. Instead the charge carrier transport layer 60 is deposited in another stage of the process as is discussed with reference to FIG. 12A, 12B. Following step S15, in step S16 shown in FIG. 10A, 10B, an opening 54 is formed in the second electrode layer 50. This can be achieved by a wet etching step selected for the second electrode layer 50. For example using a PES (Phosphoric Acid, Acetic Acid, Sulphoric acid The last is now often replaced with Nitric acid) solution in case of a second electrode 50 formed by an aluminum layer or having an aluminum layer as a main layer which is sandwiched between auxiliary layers, e.g. formed by molybdenum. Alternatively, if the second electrode 50 is formed by conductive oxide layer, such as ITO, a HCL-FeCl solution may be used as the etching agent. Still alternatively an isotropic or anisotropic plasma etching step may be used in step S16A.

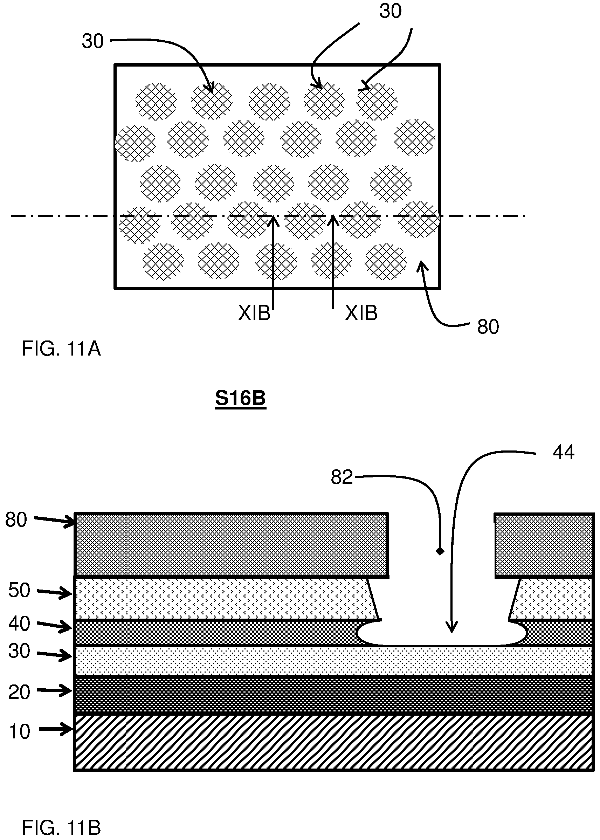

In a next step S16B, as shown in FIG. 11A, 11B, an opening 44 is formed in the insulating layer 40, to expose the surface of the charge carrier transport layer 30. An isotropic plasma etching step, for example using $CF_4/O_2$ may be applied. Also wet etching can be used. E.G. $NH_4F$ if a siliconoxide isolator is used.

In a further step S16C, a second charge carrier transport layer 60, is deposited in an electroplating process, therewith using the layer 50 as the electrode. Due to the curved edge 55 of the opening formed in the electrode 50, an increased electric field is obtained that enhances the deposition speed near the opening. By way of example, a hole transport layer may be deposited as the charge carrier transport layer 60, e.g. CuSCN using a solution of CuSO4/ Nitrilotriacetic acid /KSCN. Alternatively, the charge carrier transport layer 60 may be deposited from an ionic liquid.

Then in step S17, which is comparable to step S7 as disclosed with reference to FIG. 5, a photo-electric conversion layer 70 is deposited.

In the photo-voltaic element so obtained, the extensions 72 taper outward in a direction from the first charge carrier transport layer 30 towards the second charge carrier layer 60. As a result of the electroplating process used for the second charge carrier transport layer 60, the material thereof covers a surface of the second electrode 50 surrounding the extensions 72. Using an isotropic etching process, the openings formed will taper outward towards the second charge carrier layer 60 with an angle of approximately 45 degrees, so that the perimeter of the opening at the contact-surface of the first charge carrier transport layer is displaced with respect to the perimeter at the level of the surface of the second charge carrier transport layer is of the order of magnitude of the total thickness of the layers in which the opening is formed. For example, if the effective cross-section Deff of the opening with which the first charge carrier layer 30 is to be exposed, as defined by the mask used for etching is 1 micron, and the thicknesses of the second electrode layer 50 and the insulating layer 40 are 100 nm and 300 nm respectively, then at the plane surface of the second charge carrier transport layer 60, the cross-section Dout may be about 1.8 micron. As the electroplated second charge carrier layer 60 also has a portion 65 that extends over the tapering wall of the opening the contact surface of the second charge carrier transport layer 60 available for the photovoltaic layer 70 to be deposited in the next step is increased as compared to the situation in FIG. 4B for example. In the embodiment of FIG. 12B, the available contact surface At formed by the tapering hole in the second charge carrier transport layer is

At = $\pi$H(Deff+$\alpha$H) wherein H is the height of the electrode layer 50 and $\alpha$ is the inclination factor with which the diameter widens towards the surface 67 of the second charge carrier transport layer 60. I.e. the inclination factor $\alpha$ is defined by

$$\alpha = (Dout-Deff)/2H.$$

This additional surface At is illustrated as the hatched are At in FIG. 12D This is compared with the situation in FIG. 4B. In that case, an annulus having an inner diameter Deff and an outer diameter Dout would be additionally available at the surface 67 of the second charge carrier transport layer. The surface Ac of this area between the dashed circle in FIG. 12C and area removed by the opening to give access to the first charge carrier transport layer 30 is equal to

$$Ac = 1/2\ \pi\alpha DH + \pi\alpha^2 H^2$$

Hence the difference in the surface At and the surface Ac is equal to

$$\Delta A = At\text{-}Ac = \pi(1-\alpha/2)DH + \pi\alpha(1-\alpha)H^2$$

Accordingly, if $\alpha$ is in a range between 0 and 1, the contact surface area of the second charge carrier layer 60 is always improved. Furthermore an improvement may be obtained in the range $1<\alpha<2$, provided that: $\pi(1-\alpha/2)D>\pi\alpha(1-\alpha)H$. It is noted that the height of the second charge carrier transport layer 60 typically is substantially smaller than the height of the second electrode layer. However, for visibility the height of this layer 60 is exaggerated.

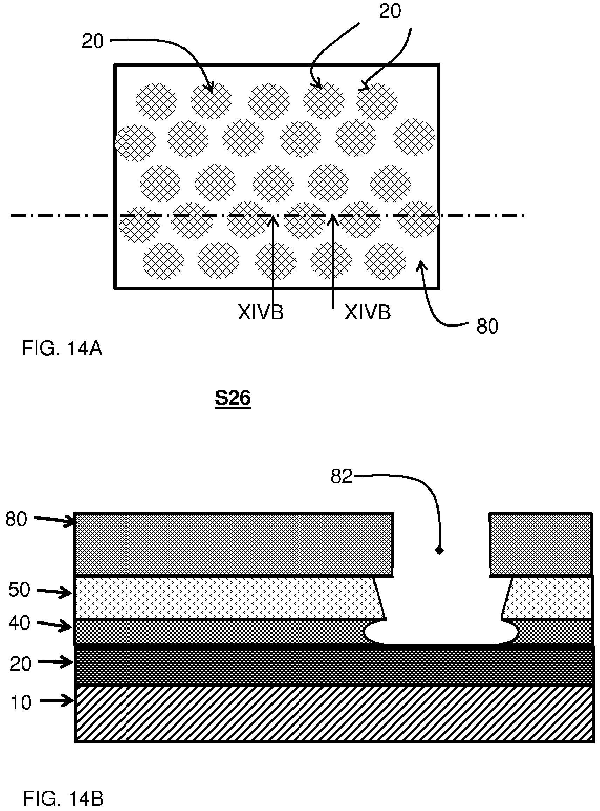

An alternative embodiment of the method is illustrated in FIG. 14A, 14B, 15A, 16B.

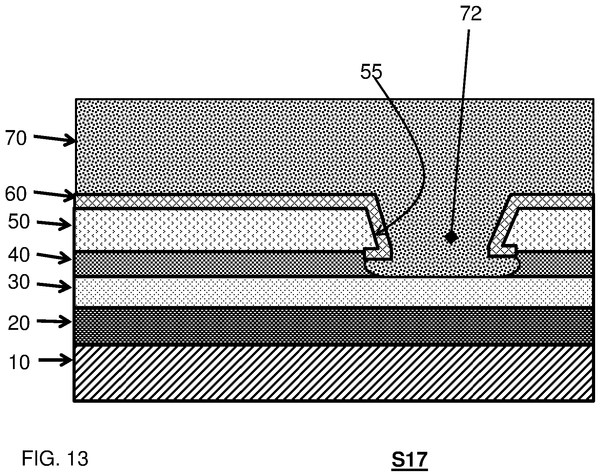

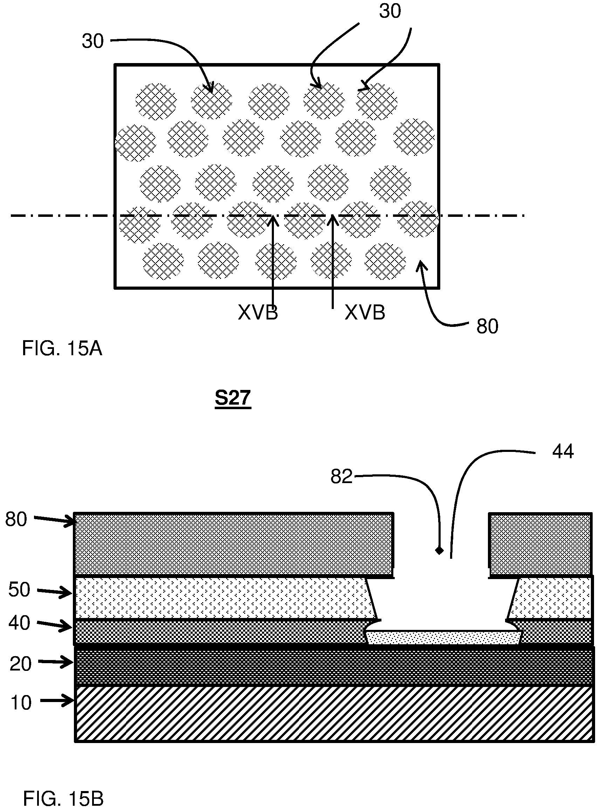

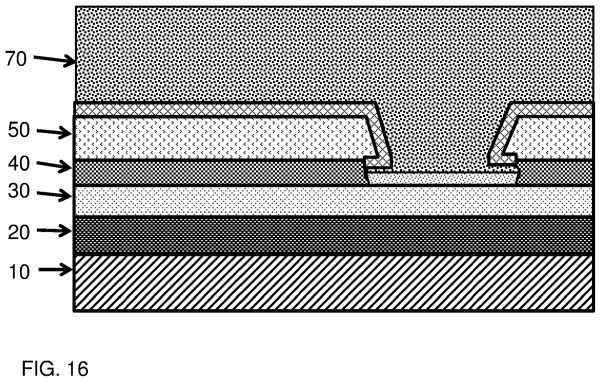

The preparatory steps with which the semi-finished product as shown in FIG. 14A, 14B is obtained after step S26, differ from those used for the semi-finished product of FIG. 11A, 11B, in that no first charge-carrier transport layer 30 is deposited. Instead, in the subsequent step S27 as shown in FIG. 15A, 15B, the first charge-carrier transport layer 30 is deposited locally on the exposed portions of the surface of the first electrode layer 20, using an electroplating process. E.g. electroplating of an ETL like $SnO_2$ from a solution of 20 mM tin chloride ($SnCl_2$) and 75 mM nitric acid Starting from here, also the second charge-carrier transport layer 60 can be deposited, as shown in FIG. 12A, 12B and a photo-electric conversion layer 70 can be deposited as shown in FIG. 13. The second charge carrier transport layer, in this case a HTL, may be deposited for example from CuSCN using a solution of CuSO4/ Nitrilotriacetic acid /KSCN. The product so obtained, as shown in FIG. 16, is characterized in that the first charge carrier layer 30 is absent in areas of the first electrode layer 20 covered by the insulating layer 40. In an alternative embodiment, electrodeposition may be used to deposit a hole transport layer as the first charge carrier transport layer 30 and to deposit an electron transport layer as the second charge carrier transport layer 60.

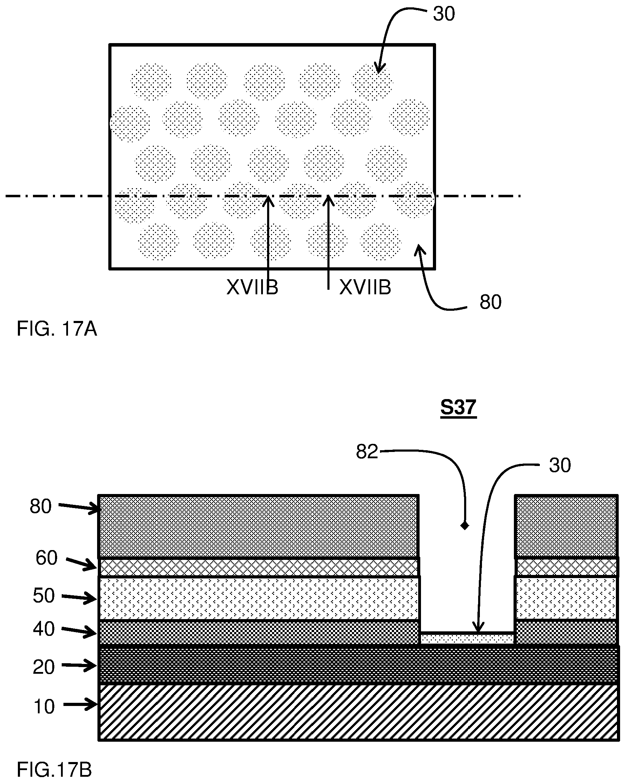

It is still further possible that only the first charge-carrier layer 30 is deposited by electro-plating. For example, starting from a semi-finished product, differing from the semi-finished product of FIG. 2A, 2B, in that a first charge carrier transport layer 30 is absent, an opening may be formed in the layers 40, 50 and 60 in steps as described with reference to FIG 3A, 3B, or as described with reference to FIG. 10A, 10B, 11A, 11B, and subsequently an electro-plating step S37 can be used to deposit a first charge carrier layer 30 on the exposed portions of the surface of the first electrode 20, as shown in FIG. 17A, 17B. Also in this case, the product which is obtained is characterized in that the first charge carrier layer 30 is absent in areas of the first electrode layer 20 covered by the insulating layer 40.

While the invention has been illustrated and described in detail in the drawings and foregoing description, such illustration and description are to be considered illustrative and exemplary and not restrictive; the invention is not limited to the disclosed embodiments. Other variations to the disclosed embodiments can be understood and effected by those skilled in the art in practicing the claimed invention, from a study of the drawings, the disclosure and the appended claims.

In the claims the word "comprising" does not exclude other elements or steps, and the indefinite article "a" or "an" does not exclude a plurality. A single processor or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A photo-voltaic element (1) comprising a stack of layers, the stack of layers at least including the following layers arranged in the order named:

   - a first electrode layer (20) for receiving charge carriers of a first polarity,
   - a first charge carrier transport layer (30), for transport of charge carriers having said first polarity,
   - an insulating layer (40),
   - a second electrode layer (50) for receiving charge carriers of a second polarity opposite to said first polarity,
   - a second charge carrier transport layer (60), for transport of charge carriers having said second polarity,
   - a photo-electric conversion layer (70) wherein charge carriers of the first polarity have a first mobility and wherein charge carriers of the second polarity have a second mobility, the photo-electric conversion layer (70) comprising a plurality of distributed extensions (72) extending through said second charge carrier transport layer (60), said second electrode layer (50) and said insulating layer (40) to the first charge carrier transport layer (30), the extensions (72) having an effective cross-section $D_{eff}$ in the range of 0.5 to 10 micron, and having an average pitch in the range of 1.1 to 5 times said effective cross-section, the effective cross-section being a diameter of a circle having an area corresponding to the cross-sectional area $A_{\varnothing}$ of the extensions, and the extensions having a circumference O that is less than 10 times the effective diameter $D_{eff}$, a contact-surface of the photo-electric conversion layer (70) with the first charge carrier transport layer (30) having a first surface area, and a contact-surface of the photo-electric conversion layer (70) with the second charge carrier transport layer (50) having a second surface area, a ratio between the second surface area and the first surface area being approximately equal to a ratio between the first mobility and the second mobility.

**2.** The photo-voltaic element according to claim 1, wherein said second electrode layer (50) has anodized edge surfaces (52) facing the extensions (72) of the photo-electric conversion layer (70).

**3.** The photo-voltaic element according to claim 1, wherein an insulating material is provided around said extensions (72), forming an insulating wall (78) between said second electrode layer (50) and said photo-electric conversion layer (70).

**4.** The photo-voltaic element according to claim 1, 2 or 3, further comprising a growth layer (74) at an interface between said photo-electric conversion layer (70) and said second charge carrier transport layer (60) as well as at an interface between said extensions (72) of the photo-electric conversion layer and each of edge surfaces of said second charge carrier transport layer (60), said second electrode layer (50) and said insulating layer (40) and at an interface between said extensions of the photo-electric conversion layer and the first charge carrier transport layer (30).

**5.** The photo-voltaic element according to one of the previous claims, wherein the photo-electric conversion layer is provided of a perovskite material.

**6.** The photo-voltaic element according to one of the previous claims, wherein the photo-electric conversion layer is made of copper indium gallium selenide (CIGS).

**7.** The photo-voltaic element according to one of the previous claims, wherein an edge portion of an upper surface of the first electrode layer (20) is kept free from material of the first charge carrier transport layer (30) and is provided with a first electrical contact (25) and or an edge portion of an upper surface of the second electrode layer (50) is kept free from material of the second charge carrier transport layer (60) and is provided with a second electrical contact (55).

**8.** The photo-voltaic element according to one of the previous claims, wherein said first electrode layer (20), said first charge carrier transport layer (30), said insulating layer (40) and said second electrode layer (50) are provided as a plurality of layer segments, wherein a plurality of lateral sub-stack segments each comprise a respective first electrode layer segment (20A, 20B), a first charge carrier transport layer segment (30A, 30B), an insulating layer segment (40A, 40B) and a second electrode layer segment (50A, 50B), wherein a second electrode layer segment (50A) of a lateral sub-stack segment extends over a first electrode layer segment (20B) in a neighboring sub-stack segment, therewith forming an electrical connection between said second electrode layer segment (50A) of said lateral sub-stack segment and said first electrode layer segment (20B) in said neighboring lateral sub-stack segment.

**9.** The photo-voltaic element according to claim 1, wherein the extensions (72) taper outward in a direction from the first charge carrier transport layer (30) towards the second charge carrier layer (60).

**10.** The photo-voltaic element according to claim 9, wherein a material of the second charge carrier transport layer (60) covers a surface of the second electrode (50) surrounding the extensions (72).

**11.** The photo-electric element according to one of the previous claims, wherein the first charge carrier layer (30) is absent in areas of the first electrode layer (20) covered by the insulating layer (40).

**12.** Method of manufacturing a photo-voltaic element comprising the steps of:

- providing (S1) a substrate (10);
- depositing (S2) thereon a stack of layers comprising at least in the order named:
- a first electrode layer (20) for receiving charge carriers of a first polarity;
- a first charge carrier transport layer (30), for transport of charge carriers having said first polarity;
- an insulating layer (40);- a second electrode layer (50) for receiving charge carriers of a second polarity opposite to said first polarity; wherein the insulating layer and layers subsequently deposited in this step (S2) form a substack having an upper surface (64),
- applying (S3) a resist layer (80) on said upper surface, wherein said resist layer is provided (S4) with a plurality of distributed openings (82) towards said upper surface, the openings having an effective cross-section D in the range of 0.5 to 10 micron, and having an average pitch in the range of 1.1 to 5 times said effective cross-section, the effective cross-section being a diameter of a circle having an area corresponding to the cross-sectional area $A_{\varnothing}$ of the extensions, and the extensions having a circumference O that is less than 10 times the effective diameter $D_{eff}$,
- etching (S5) to selectively remove material of the sub-stack facing the openings (82),
- removing (S6) the resist layer subsequent to said etching,
- depositing (S7) and curing a photo-electric conversion layer (70) subsequent to said removing,

the method further comprising depositing a second charge carrier transport layer (60), for transport of charge carriers having said second polarity,

wherein charge carriers of the first polarity and charge carriers of the second polarity respectively have a first and a second mobility, wherein a contact-surface of the photo-electric conversion layer (70) with the first charge carrier transport layer (30) and a contact-surface of the photo-electric conversion layer (70) with the second charge carrier transport layer (60) respectively have a first and a second surface area,

wherein a ratio between the second surface area and the first surface area is approximately equal to a ratio between the first mobility and the second mobility,

wherein either said depositing a second charge carrier transport layer (60) is subsequent to said depositing a second electrode layer and preceding said depositing a resist layer, or wherein said depositing a second charge carrier transport layer (60) is performed with an electroplating process subsequent to removing (S6) the resist layer and preceding depositing (S7) and curing a photo-electric conversion layer (70).

13. The method according to claim 12, wherein the first charge carrier transport layer (30) is deposited with an electroplating process.

14. The method according to claim 12, when depositing a second charge carrier transport layer (60) is subsequent to said depositing a second electrode layer and preceding said depositing a resist layer, either further comprising anodizing (S6A) an edge surface of the second electrode layer resulting from said etching, said anodizing being performed prior to the step of depositing the photo-electric conversion layer, or further comprising conformally depositing (S6C) a layer (76) of an insulating material subsequent to said step of etching (S5) and anisotropically etching (S6D) said layer (76) to remove the insulating material from the surface of the second charge carrier transport layer (60) and from the surface portions of the first charge carrier transport layer (30) within the openings (82) while keeping a layer (78) of the insulating material on the walls of the openings (82) intact.

15. The method according to claim 12 or 14 , further comprising depositing (S6B) a growth layer (74) subsequent to said step of etching (S5) and prior to the step of depositing (S7) the photo-electric conversion layer.

**Patentansprüche**

1. Photovoltaisches Element (1), das einen Stoß von Schichten umfasst, wobei der Stoß von Schichten wenigstens die folgenden Schichten einschließt, die in der genannten Reihenfolge angeordnet sind:

- eine erste Elektrodenschicht (20) zur Aufnahme von Ladungsträgern einer ersten Polarität,
- eine erste Ladungsträgertransportschicht (30), zum Transport von Ladungsträgern mit der ersten Polarität,
- eine Isolierschicht (40),
- eine zweite Elektrodenschicht (50) zur Aufnahme von Ladungsträgern einer zweiten Polarität, die der ersten Polarität entgegengesetzt ist,
- eine zweite Ladungsträgertransportschicht (60), zum Transport von Ladungsträgern mit der zweiten Polarität,
- eine photoelektrische Umwandlungsschicht (70), wobei Ladungsträger der ersten Polarität eine erste Beweglichkeit aufweisen, und wobei Ladungsträger der zweiten Polarität eine zweite Beweglichkeit aufweisen, wobei die photoelektrische Umwandlungsschicht (70) mehrere verteilte Erweiterungen (72) umfasst, die sich durch die zweite Ladungsträgertransportschicht (60), die zweite Elektrodenschicht (50) und die Isolierschicht (40) zur ersten Ladungsträgertransportschicht (30) erstrecken, wobei die Erweiterungen (72) einen effektiven Querschnitt $D_{eff}$ im Bereich von 0,5 bis 10 Mikron aufweisen und einen mittleren Abstand im Bereich von 1,1 bis zum 5-fachen des effektiven Querschnitts aufweisen, wobei der effektive Querschnitt ein Durchmesser eines Kreises mit einer Fläche ist, die der Querschnittsfläche A0 der Erweiterungen entspricht, und die Erweiterungen einen Umfang O aufweisen, der kleiner als das 10-fache des effektiven Durchmessers $D_{eff}$ ist, wobei eine Kontaktfläche der photoelektrischen Umwandlungsschicht (70) mit der ersten Ladungsträgertransportschicht (30) eine erste Oberfläche aufweist, und eine Kontaktfläche der photoelektrischen Umwandlungsschicht (70) mit der zweiten Ladungsträgertransportschicht (50) eine zweite Oberfläche aufweist, wobei ein Verhältnis zwischen der zweiten Oberfläche und der ersten Oberfläche etwa gleich einem Verhältnis zwischen der ersten Mobilität und der zweiten Mobilität ist.

2. Photovoltaisches Element nach Anspruch 1, wobei die zweite Elektrodenschicht (50) anodisierte Randflächen (52) aufweist, die den Erweiterungen (72) der photoelektrischen Umwandlungsschicht (70) zugewandt sind.

**3.** Photovoltaisches Element nach Anspruch 1, wobei ein isolierendes Material um die Erweiterungen (72) herum vorgesehen ist, das eine isolierende Wand (78) zwischen der zweiten Elektrodenschicht (50) und der photoelektrischen Umwandlungsschicht (70) bildet.

**4.** Photoelektrisches Element nach Anspruch 1, 2 oder 3, ferner umfassend eine Wachstumsschicht (74) an einer Schnittstelle zwischen der photoelektrischen Umwandlungsschicht (70) und der zweiten Ladungsträgertransportschicht (60) sowie an einer Schnittstelle zwischen den Erweiterungen (72) der photoelektrischen Umwandlungsschicht und jeder der Randflächen der zweiten Ladungsträgertransportschicht (60), der zweiten Elektrodenschicht (50) und der Isolierschicht (40) und an einer Schnittstelle zwischen den Erweiterungen der photoelektrischen Umwandlungsschicht und der ersten Ladungsträgertransportschicht (30).

**5.** Photovoltaisches Element nach einem der vorhergehenden Ansprüche, wobei die photoelektrische Umwandlungsschicht aus einem Perowskit-Material vorgesehen ist.

**6.** Photovoltaisches Element nach einem der vorhergehenden Ansprüche, wobei die photoelektrische Umwandlungsschicht aus Kupfer-Indium-Gallium-Selenid (CIGS) hergestellt ist.

**7.** Photovoltaisches Element nach einem der vorhergehenden Ansprüche, wobei ein Randabschnitt einer oberen Fläche der ersten Elektrodenschicht (20) vom Material der ersten Ladungsträgertransportschicht (30) freigehalten wird und mit einem ersten elektrischen Kontakt (25) versehen ist und/oder ein Randabschnitt einer oberen Fläche der zweiten Elektrodenschicht (50) vom Material der zweiten Ladungsträgertransportschicht (60) freigehalten wird und mit einem zweiten elektrischen Kontakt (55) versehen ist.

**8.** Photovoltaisches Element nach einem der vorhergehenden Ansprüche, wobei die erste Elektrodenschicht (20), die erste Ladungsträgertransportschicht (30), die Isolierschicht (40) und die zweite Elektrodenschicht (50) als mehrere Schichtsegmente vorgesehen sind, wobei mehrere laterale Unterstoßesegmente jeweils ein jeweiliges erstes Elektrodenschichtsegment (20A, 20B), ein erstes Ladungsträgertransportschichtsegment (30A, 3OB) ein Isolierschichtsegment (40A, 40B) und ein zweites Elektrodenschichtsegment (50A, 50B) umfassen, wobei sich ein zweites Elektrodenschichtsegment (50A) eines lateralen Unterstoßesegments über ein erstes Elektrodenschichtsegment (20B) in einem benachbarten Unterstoßesegment erstreckt und damit eine elektrische Verbindung zwischen dem zweiten Elektrodenschichtsegment (50A) des lateralen Unterstoßesegments und dem ersten Elektrodenschichtsegment (20B) in dem benachbarten lateralen Unterstoßesegment bildet.

**9.** Photovoltaisches Element nach Anspruch 1, wobei sich die Erweiterungen (72) in einer Richtung von der ersten Ladungsträgertransportschicht (30) zur zweiten Ladungsträgerschicht (60) hin verjüngen.

**10.** Photovoltaisches Element nach Anspruch 9, wobei ein Material der zweiten Ladungsträgertransportschicht (60) eine die Erweiterungen (72) umgebende Oberfläche der zweiten Elektrode (50) abdeckt.

**11.** Photoelektrisches Element nach einem der vorhergehenden Ansprüche, wobei die erste Ladungsträgerschicht (30) in Flächen der ersten Elektrodenschicht (20), die von der Isolierschicht (40) abgedeckt sind, nicht vorhanden ist.

**12.** Verfahren zur Herstellung eines photovoltaischen Elements, das die Schritte umfasst:

- Bereitstellung (S1) eines Substrats (10);
- Abscheiden (S2) darauf eines Stoßes von Schichten, der wenigstens in der genannten Reihenfolge umfasst:

   - eine erste Elektrodenschicht (20) zur Aufnahme von Ladungsträgern einer ersten Polarität;
   - eine erste Ladungsträgertransportschicht (30), zum Transport von Ladungsträgern mit der ersten Polarität;
   - eine Isolierschicht (40);
   - eine zweite Elektrodenschicht (50) zur Aufnahme von Ladungsträgern einer zweiten Polarität, die der ersten Polarität entgegengesetzt ist; wobei die Isolierschicht und die in diesem Schritt (S2) nachfolgend abgeschiedenen Schichten einen Unterstoß mit einer oberen Fläche (64) bilden,

- Aufbringen (S3) einer Resistschicht (80) auf die obere Oberfläche, wobei die Resistschicht mit mehreren verteilten Öffnungen (82) in Richtung der oberen Fläche versehen ist (S4), wobei die Öffnungen einen effektiven Querschnitt D im Bereich von 0,5 bis 10 Mikron und einen mittleren Abstand im Bereich des 1,1- bis 5-fachen des effektiven Querschnitts aufweisen, wobei der effektive Querschnitt ein Durchmesser eines Kreises mit einer Fläche ist, die der Querschnittsfläche A0 der Erweiterungen entspricht, und die Erweiterungen einen Umfang O haben, der kleiner als das 10-fache des effektiven Durchmessers $D_{eff}$ ist,

- Ätzen (S5) zum selektiven Entfernen vom Material des Unterstoßes, der den Öffnungen (82) zugewandt ist,
- Entfernen (S6) der Resistschicht nach dem Ätzen,
- Abscheiden (S7) und Härten einer photoelektrischen Umwandlungsschicht (70) nach dem Entfernen,

wobei das Verfahren ferner das Abscheiden einer zweiten Ladungsträgertransportschicht (60) zum Transport von Ladungsträgern mit der zweiten Polarität umfasst,

wobei Ladungsträger der ersten Polarität bzw. Ladungsträger der zweiten Polarität jeweils eine erste und eine zweite Beweglichkeit aufweisen, wobei eine Kontaktfläche der photoelektrischen Umwandlungsschicht (70) mit der ersten Ladungsträgertransportschicht (30) bzw. eine Kontaktfläche der photoelektrischen Umwandlungsschicht (70) mit der zweiten Ladungsträgertransportschicht (60) jeweils eine erste und eine zweite Oberfläche aufweisen, wobei ein Verhältnis zwischen der zweiten Oberfläche und der ersten Oberfläche ungefähr gleich einem Verhältnis zwischen der ersten Mobilität und der zweiten Mobilität ist, wobei entweder das Abscheiden einer zweiten Ladungsträgertransportschicht (60) nach dem Abscheiden einer zweiten Elektrodenschicht und vor dem Abscheiden einer Resistschicht erfolgt, oder wobei das Abscheiden einer zweiten Ladungsträgertransportschicht (60) mit einem Galvanisierungsprozess nach dem Entfernen (S6) der Resistschicht und vor dem Abscheiden (S7) und Härten einer photoelektrischen Umwandlungsschicht (70) durchgeführt wird.

13. Verfahren nach Anspruch 12, wobei die erste Ladungsträgertransportschicht (30) mit einem galvanischen Verfahren abgeschieden wird.

14. Verfahren nach Anspruch 12, wenn das Abscheiden einer zweiten Ladungsträgertransportschicht (60) nach dem Abscheiden einer zweiten Elektrodenschicht und vor dem Abscheiden einer Resistschicht erfolgt, entweder ferner umfassend das Anodisieren (S6A) einer Randfläche der zweiten Elektrodenschicht, die sich aus dem Ätzen ergibt, wobei das Anodisieren vor dem Schritt des Abscheidens der photoelektrischen Umwandlungsschicht durchgeführt wird, oder ferner umfassend das konforme Abscheiden (S6C) einer Schicht (76) aus einem isolierenden Material nach dem Schritt des Ätzens (S5) und das anisotrope Ätzen (S6D) der Schicht (76), um das isolierende Material von der Fläche der zweiten Ladungsträgertransportschicht (60) und von den Flächenabschnitten der ersten Ladungsträgertransportschicht (30) innerhalb der Öffnungen (82) zu entfernen, während eine Schicht (78) des isolierenden Materials auf den Wänden der Öffnungen (82) intakt gehalten wird.

15. Verfahren nach Anspruch 12 oder 14, ferner umfassend das Abscheiden (S6B) einer Wachstumsschicht (74) nach dem Schritt des Ätzens (S5) und vor dem Schritt des Abscheidens (S7) der photoelektrischen Umwandlungsschicht.

**Revendications**

1. Élément photovoltaïque (1) comprenant une pile de couches, la pile de couches au moins comprenant les couches suivantes agencées dans l'ordre indiqué :

   - une première couche d'électrode (20) pour recevoir des porteurs de charge d'une première polarité,
   - une première couche de transport de porteurs de charge (30), pour un transport de porteurs de charge ayant ladite première polarité,
   - une couche isolante (40),
   - une seconde couche d'électrode (50) pour recevoir des porteurs de charge d'une seconde polarité opposée à ladite première polarité,
   - une seconde couche de transport de porteurs de charge (60), pour un transport de porteurs de charge ayant ladite seconde polarité,
   - une couche de conversion photoélectrique (70), où les porteurs de charge de la première polarité ont une première mobilité et où les porteurs de charge de la seconde polarité ont une seconde mobilité, la couche de conversion photoélectrique (70) comprenant une pluralité d'extensions réparties (72) s'étendant à travers ladite seconde couche de transport de porteurs de charge (60), ladite seconde couche d'électrode (50) et ladite couche isolante (40) jusqu'à la première couche de transport de porteurs de charge (30), les extensions (72) ayant une section transversale effective $D_{eff}$ dans la plage de 0,5 à 10 microns, et ayant un pas moyen dans la plage de 1,1 à 5 fois ladite section transversale effective, la section transversale effective étant un diamètre d'un cercle ayant une aire correspondant à l'aire de section transversale $A_\varnothing$ des extensions, et les extensions ayant une circonférence O qui est inférieure à 10 fois le diamètre effectif $D_{eff}$, une surface de contact de la couche de conversion photoélectrique (70) avec la première couche de transport de porteurs de charge (30) ayant une première superficie et une surface de contact de la couche de conversion photoélectrique (70) avec la seconde couche de transport de porteurs de charge (50) ayant une seconde superficie, un rapport entre la seconde superficie et la première superficie étant approximativement égal à un rapport entre la première mobilité et la seconde mobilité.

2. Élément photovoltaïque selon la revendication 1, dans lequel ladite seconde couche d'électrode (50) a des surfaces de bord anodisées (52) faisant face aux extensions (72) de la couche de conversion photo-électrique (70).

3. Élément photovoltaïque selon la revendication 1, dans lequel un matériau isolant est prévu autour desdites extensions (72), formant une paroi isolante (78) entre ladite seconde couche d'électrode (50) et ladite couche de conversion photoélectrique (70).

4. Élément photovoltaïque selon la revendication 1, 2 ou 3, comprenant en outre une couche de croissance (74) au niveau d'une interface entre ladite couche de conversion photo-électrique (70) et ladite seconde couche de transport de porteurs de charge (60) ainsi qu'au niveau d'une interface entre lesdites extensions (72) de la couche de conversion photoélectrique et chacune de surfaces de bord de ladite seconde couche de transport de porteurs de charge (60), ladite seconde couche d'électrode (50) et ladite couche isolante (40) et au niveau d'une interface entre lesdites extensions de la couche de conversion photoélectrique et la première couche de transport de porteurs de charge (30).

5. Élément photovoltaïque selon l'une des revendications précédentes, dans lequel la couche de conversion photo-électrique est constituée d'un matériau de pérovskite.

6. Élément photovoltaïque selon l'une des revendications précédentes, dans lequel la couche de conversion photo-électrique est en séléniure de cuivre-indium-gallium (CIGS).

7. Élément photovoltaïque selon l'une des revendications précédentes, dans lequel une partie de bord d'une surface supérieure de la première couche d'électrode (20) est maintenue exempte de matériau de la première couche de transport de porteurs de charge (30) et est pourvue d'un premier contact électrique (25) et/ou une partie de bord d'une surface supérieure de la seconde couche d'électrode (50) est maintenu exempte de matériau de la seconde couche de transport de porteurs de charge (60) et est pourvue d'un second contact électrique (55).

8. Élément photovoltaïque selon l'une des revendications précédentes, dans lequel ladite première couche d'électrode (20), ladite première couche de transport de porteurs de charge (30), ladite couche isolante (40) et ladite seconde couche d'électrode (50) sont prévues sous la forme d'une pluralité de segments de couche, dans lequel une pluralité de segments de sous-pile latéraux comprennent chacun un segment de première couche d'électrode respectif (20A, 20B), un segment de première couche de transport de porteurs de charge (30A, 30B), un segment de couche isolante (40A, 40B) et un segment de seconde couche d'électrode (50A, 50B), dans lequel un segment de seconde couche d'électrode (50A) d'un segment de sous-pile latéral s'étend au-dessus d'un segment de première couche d'électrode (20B) dans un segment de sous-pile voisin, en formant ainsi une connexion électrique entre ledit segment de seconde couche d'électrode (50A) dudit segment de sous-pile latéral et ledit segment de première couche d'électrode (20B) dans ledit segment de sous-pile latéral voisin.

9. Élément photovoltaïque selon la revendication 1, dans lequel les extensions (72) sont effilées vers l'extérieur dans une direction allant de la première couche de transport de charge (30) vers la seconde couche de support de charge (60).

10. Élément photovoltaïque selon la revendication 9, dans lequel un matériau de la seconde couche de transport de porteurs de charge (60) recouvre une surface de la seconde électrode (50) entourant les extensions (72).

11. Élément photoélectrique selon l'une des revendications précédentes, dans lequel la première couche de support de charge (30) est absente dans des zones de la première couche d'électrode (20) recouvertes par la couche isolante (40).

12. Procédé de fabrication d'un élément photovoltaïque, comprenant les étapes consistant à :

- fournir (S1) un substrat (10) ;
- déposer (S2) dessus un pile de couches comprenant au moins dans l'ordre indiqué :

- une première couche d'électrode (20) pour recevoir des porteurs de charge d'une première polarité,
- une première couche de transport de porteurs de charge (30), pour un transport de porteurs de charge ayant ladite première polarité,
- une couche isolante (40),
- une seconde couche d'électrode (50) pour recevoir des porteurs de charge d'une seconde polarité opposée à ladite première polarité ;

dans lequel la couche isolante et les couches déposées ultérieurement dans cette étape (S2) forment une sous-pile ayant une surface supérieure (64),

- appliquer (S3) une couche de réserve (80) sur ladite surface supérieure, dans lequel ladite couche de réserve est pourvue (S4) d'une pluralité d'ouvertures réparties (82) vers ladite surface supérieure, les ouvertures ayant une section transversale effective D dans la plage de 0,5 à 10 microns, et ayant un pas moyen dans la plage de 1,1 à 5 fois ladite section transversale effective, la section transversale effective étant un diamètre d'un cercle ayant une aire correspondant à l'aire de section transversale $A_\varnothing$ des extensions, et les extensions ayant une circonférence O qui est inférieure à 10 fois le diamètre effectif $D_{eff}$,
- attaquer chimiquement (S5) pour éliminer sélectivement du matériau de la sous-pile faisant face aux ouvertures (82),
- retirer (S6) la couche de réserve après ladite attaque chimique,
- déposer (S7) et durcir une couche de conversion photoélectrique (70) après ledit retrait,

le procédé comprenant en outre le dépôt d'une seconde couche de transport de porteurs de charge (60), pour un transport de porteurs de charge ayant ladite seconde polarité,

dans lequel les porteurs de charge de la première polarité et les porteurs de charge de la seconde polarité ont respectivement une première et une seconde mobilité,

dans lequel une surface de contact de la couche de conversion photoélectrique (70) avec la première couche de transport de porteurs de charge (30) et une surface de contact de la couche de conversion photoélectrique (70) avec la seconde couche de transport de porteurs de charge ont respectivement une première et une seconde superficie,

dans lequel un rapport entre la seconde superficie et la première superficie est approximativement égal à un rapport entre la première mobilité et la seconde mobilité,

dans lequel ledit dépôt d'une seconde couche de transport de porteurs de charge (60) est après ledit dépôt d'une seconde couche d'électrode et précédant ledit dépôt d'une couche de réserve, ou dans lequel ledit dépôt d'une seconde couche de transport de porteurs de charge (60) est effectué avec un processus de dépôt électrolytique après le retrait (S6) de la couche de réserve et précédant le dépôt (S7) et le durcissement d'une couche de conversion photoélectrique (70).

13. Procédé selon la revendication 12, dans lequel la première couche de transport de porteurs de charge (30) est déposée avec un procédé de dépôt électrolytique.

14. Procédé selon la revendication 12, lorsque le dépôt d'une seconde couche de porteurs de charge (60) est ultérieur audit dépôt d'une seconde couche d'électrode et précède ledit dépôt d'une couche de réserve, comprenant en outre l'anodisation (S6A) d'une surface de bord de la seconde couche d'électrode résultant de ladite attaque chimique, ladite anodisation étant réalisée avant l'étape de dépôt de la couche de conversion photoélectrique, ou comprenant en outre un dépôt conforme (S6C) d'une couche (76) d'un matériau isolant suite à ladite étape d'attaque chimique (S5) et d'attaque chimique anisotrope (S6D) de ladite couche (76) pour retirer le matériau isolant de la surface de la seconde couche de transport de porteurs de charge (60) et des parties de surface de la première couche de transport de porteurs de charge (30) à l'intérieur des ouvertures (82) tout en maintenant une couche (78) du matériau isolant sur les parois des ouvertures (82) intacte.

15. Procédé selon la revendication 12 ou 14, comprenant en outre le dépôt (S6B) d'une couche de croissance (74) à la suite de ladite étape d'attaque chimique (S5) et avant l'étape de dépôt (S7) de la couche de conversion photoélectrique.

FIG. 1A

FIG. 1B

FIG. 2A

<u>S4</u>

FIG. 2B

30

IIIB      IIIB

80

FIG. 3A

S5

82

80
60
50
40
30
20
10

FIG.3B

FIG.4A

**30**

IVB    IVB

**80**                                                                      **60**

**S6**

52(**S6A**)

60

50

40

30

20

10

FIG.4B

**S6B**

74

60

50

40

30

20

10

FIG.4C

**S6**

80

60
50
40
30
20
10

FIG.4D

**S6C**

82

76
60
50
40
30
20
10

FIG.4E

**S6D**

82

78

60

50

40

30

20

10

FIG.4F

**S6E**

72

78

70

60

50

40

30

20

10

FIG.4G

FIG. 5

FIG. 6

FIG. 7

AB

A                    B                    C,D, .......

30

VIIIB    VIIIB

70

1

FIG. 8A

AB

70

60

50A

40A

30A

20A

10

50B

40B

30B

20B

FIG. 8B

FIG. 9A

**S15**

FIG. 9B

40

40

40

XB          XB

80

FIG. 10A

**S16A**

82          54

80
50
40
30
20
10

FIG. 10B

EP 3 610 514 B1

FIG. 11A

**S16B**

FIG. 11B

30

30

30

60

**S16C**

FIG. 12A

XIIB    XIIB

Dout

Deff

67

60

50

40

30

20

10

65

FIG. 12B

Ac

30

30

At

60

60

FIG. 12C

FIG. 12D

72

55

70

60

50

40

30

20

10

FIG. 13                                                S17

20

20

20

XIVB    XIVB

80

FIG. 14A

<u>S26</u>

82

80

50

40

20

10

FIG. 14B

30

30

30

XVB          XVB

80

FIG. 15A

<u>S27</u>

44

82

80

50

40

20

10

FIG. 15B

FIG. 16

30

XVIIB     XVIIB

80

FIG. 17A

**S37**

82

30

80

60

50

40

20

10

FIG.17B

**REFERENCES CITED IN THE DESCRIPTION**

**Patent documents cited in the description**

- CN 105140398
- WO 2017060700 A